# EUROPEAN PATENT SPECIFICATION

(11) **EP 1 592 128 B1**
(45) Date of publication and mention of the grant of the patent: **02.05.2007**
(21) Application number: 05008426.8
(22) Date of filing: 18.04.2005
(51) Int. Cl.: H03F 3/19

(54) **High-frequency amplifier**
Hochfrequenzverstärker
Amplificateur haute fréquence

(30) Priority: 30.04.2004 JP 2004136044
(43) Date of publication of application: 02.11.2005
(73) Proprietor: ALPS ELECTRIC CO., LTD., Tokyo 145-8501 (JP)
(72) Inventor: Sato, Keiichiro c/o ALPS ELECTRIC CO.,LTD., Tokyo, 145-8501 (JP)
(74) Representative: Klunker . Schmitt-Nilson . Hirsch

(56) References cited:
- EP-A- 0 498 893
- EP-A- 1 148 550
- PATENT ABSTRACTS OF JAPAN vol. 1998, no. 14, 31 December 1998 (1998-12-31) & JP 10 233705 A (ALPS ELECTRIC CO LTD), 2 September 1998 (1998-09-02)

## Description

### BACKGROUND OF THE INVENTION

### 1. Field of the Invention

The present invention relates to a high-frequency amplifier adapted to be used in a satellite broadcast receiving down converter, and more particularly to a high-frequency amplifier which has the structure that an unnecessary transmission mode is not generated in a shield case of the high-frequency amplifier when amplifying the high-frequency signal in the band of 10 GHz ~ 12 GHz as a frequency band such that a high-frequency signal can be amplified in a high stable state.

### 2. Description of the Related Art

Conventionally, the satellite broadcast receiving down converter comprising a waveguide having a horn-shaped opening for receiving a satellite broadcast wave at one end thereof, a case coupled to the other end of the waveguide and a high-frequency amplifier for amplifying the satellite broadcast signal in a partition formed in the case is known. For example, there is a satellite broadcast receiving down converter disclosed in Japanese Unexamined Patent Application Publication No. 10-233705.

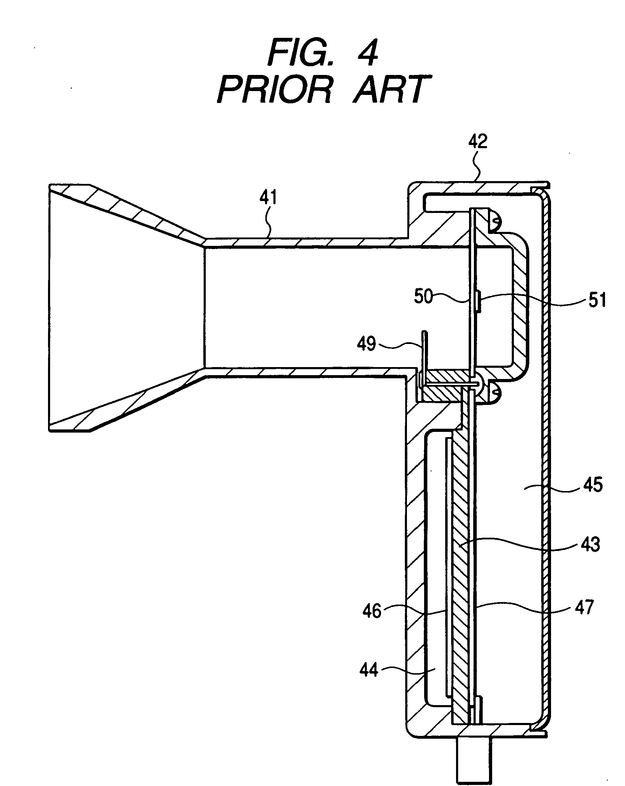

Here, Fig. 4 is a cross-sectional view showing the structure of the main parts of the satellite broadcast receiving down converter disclosed in Japanese Unexamined Patent Application Publication No. 10-233705.

As shown in Fig. 4, the satellite broadcast receiving down converter comprises a waveguide 41 having a horn-shaped opening at one end thereof and a metal case 42 which is integrally formed at the rear opening of the waveguide 41 and which is formed in an L-shape together with the waveguide 41. Also, the metal plate 43 for dividing the inside of the metal case 42 by two is provided and a first partition 44 and a second partition 45 are formed in the metal case 42. Further, a first circuit board 46 is arranged at one surface of the metal plate 43 in the first partition 44, and a second circuit board 47 is arranged at the other surface of the metal plate 43 in the second partition 45. In this case, the second circuit board 47 is extended into the inside of the rear opening of the waveguide 41, and, at the extended part, a first probe 49 protruded from the second circuit board 47 to the inside of the rear opening of the waveguide 41 for detecting a first linearly polarized wave (for example, a horizontally polarized wave) is provided. On the second circuit board 47 of the inside of the rear opening of the waveguide 41, a short-circuited pattern 50 and a second probe 51 for detecting a second linearly polarized wave (for example, a vertically polarized wave) are provided.

The satellite broadcast receiving down converter having the above-mentioned structure is schematically operated as follows: If the satellite broadcast wave is input to the waveguide 41, the first probe 49 detects the first linearly polarized wave and the second probe 51 detects the second linearly polarized wave. The first linearly polarized wave detected by the first probe 49 and the second linearly polarized wave detected by the second probe 51 are amplified by separate high-frequency amplifiers which are formed at the second circuit board 47, respectively, are divided into a low band signal (frequency of 10.7 GHz ~ 11.7 GHz) and a high band signal (frequency of 11.7 GHz ~ 12.75 GHz) by a frequency divider which is formed at the second circuit board 47, and are down-converted into separate intermediate frequency signals (frequency of 0.95 GHz ~ 1.95 GHz) by a low band frequency converter and a high band frequency converter which are formed at the first and second circuit boards 46, 47. The obtained intermediate frequency signal is supplied to the next usage equipment.

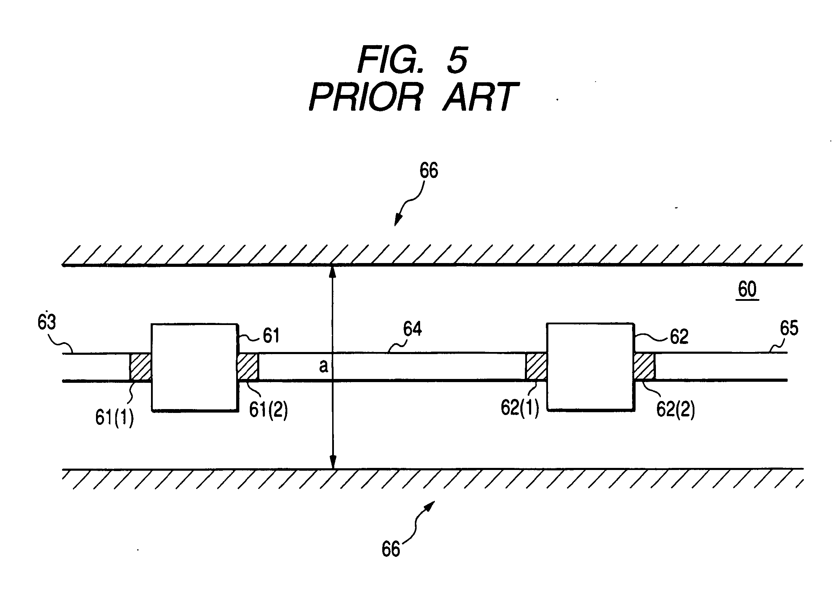

Next, Fig. 5 is a plan view showing an example of the structure of the high-frequency amplifier used in the conventional satellite broadcast receiving down converter.

As shown in Fig. 5, the high-frequency amplifier is formed on the circuit board 60, and comprises a first high-frequency amplifying circuit part 61 having a first semiconductor amplifying device and comprising an input port 61(1) and an output port 61(2), a second high-frequency amplifying circuit part 62 having a second semiconductor amplifying device and comprising an input port 62(1) and an output port 62(2), a first conducting band 63 which is connected between an amplifier input port (not shown) and the input port 61(1) of the first high-frequency amplifying circuit part 61, a second conducting band 64 which is connected between the output port 61(2) of the first high-frequency amplifying circuit part 61 and the input port 62(1) of the second high-frequency amplifying circuit part 62, a third conducting band 65 which is connected between the output port 62(2) of the second high-frequency amplifying circuit part 62 and an amplifier output port (not shown) and a shield case 66 for shielding each of the components 61~65 on the circuit board 60.

In addition, the shield case 66 used in the high-frequency amplifier is formed so that the interval between the facing sidewalls a is equal to or slightly larger than 7 mm in consideration of that the frequency band of the amplified signal is 10.7 GHz ~ 12.75 GHz. Also, in this high-frequency amplifier, HEMT (Heterojunction Mobility Field Effect Transistor) or GaAsFET (Gallium-Arsenic Field Effect Transistor) is used in the first and second semiconductor amplifying device being capable of amplifying the signal in the high frequency region so that the high-frequency signal in the frequency band of 10.7 GHz - 12.75 GHz can be amplified.

The operation of the high-frequency amplifier having the above-mentioned structure is as follows: Here, if the linearly polarized signal is supplied to the amplifier input port, the linearly polarized signal is supplied to the first high-frequency amplifying circuit part 61 through the first conducting band 63 and is amplified in the first high-frequency amplifying circuit part 61. The amplified linearly polarized signal is supplied to the second high-frequency amplifying circuit part 62 through the second conducting band 64 and is amplified in the second high-frequency amplifying circuit part 62 again. Further, the amplified linearly polarized signal again is supplied to the amplifier output port through the third conducting band 65 and is supplied from the amplifier output port to the next stage of the frequency divider (not shown).
[Patent Document 1] Japanese Unexamined Patent Application Publication No. 10-233705

In the above-mentioned high-frequency amplifier, if the rectangular waveguide is formed in the shield case 66 for shielding the high-frequency amplifier and the interval of the facing sidewalls in the shield case 66 is equal to or slightly larger than 7 mm, the cut-off frequency fc of TE₁₀ mode which is the fundamental transmission mode of the rectangular waveguide becomes about 22 GHz. Further, since the above-mentioned high-frequency amplifier uses the HEMT or the GaAsFET as the first and second semiconductor amplifying device as mentioned above, the gain equal to and larger than 0 dB may be obtained even in the frequency of about 22 GHz which is higher than 10.7 GHz ~ 12.75 GHz of the original frequency band of the high-frequency amplifier by two times. In this case, if unnecessary feedback coupling is generated in the high-frequency amplifier at the frequency of about 22 GHz, a second transmission mode other than the fundamental transmission mode is generated in the rectangular waveguide at the frequency of about 22 GHz and thus abnormal oscillation is generated in the high-frequency amplifier and the amplifying operation of the high-frequency amplifier becomes very unstable.

### SUMMARY OF THE INVENTION

The present invention is to solve the above-mentioned problem, and the object of the present invention is to provide a high-frequency amplifier which has the structure that unnecessary feedback coupling is not generated in the high-frequency amplifier so that the abnormal oscillation is prevented from being generated and a stable amplifying operation is performed.

In order to achieve the above-mentioned objects, a high-frequency amplifier according to the present invention comprises a first high-frequency amplifying circuit part which is formed on a circuit board and has a first semiconductor amplifying device, a second high-frequency amplifying circuit part which is formed on the circuit board and has a second semiconductor amplifying device, a connecting part for connecting the first high-frequency amplifying circuit part with the second high-frequency amplifying circuit part by a conducting band, and a shield case for shielding the first high-frequency amplifying circuit part, the connecting part and the second high-frequency amplifying circuit part, and comprises a means that the facing sidewalls of the shield case is provided with narrow width parts having an inner interval of 4 mm to 5 mm.

In this case, the above-mentioned means of the high-frequency amplifier comprises a first constructing means that the narrow width parts are formed at the location which the first semiconductor amplifying device and the second semiconductor amplifying device are inserted therebetween.

Furthermore, the above-mentioned means of the high-frequency amplifier comprises a second constructing means that the narrow width parts are formed at the location which the conducting band is inserted therebetween.

According to the high-frequency amplifier of the present invention, since the facing sidewalls of the shield case for shielding the high-frequency amplifier are provided with narrow width parts having an inner interval of 4 mm to 5 mm and thus the unnecessary feedback coupling is prevented from being generated by the narrow width parts, the cut-off frequency fc of TE₁₀ mode which is the fundamental transmission mode of the rectangular waveguide due to the shield case can be increased up to about 30 GHz. In this case, since the gain of the high-frequency amplifier in the frequency region of about 30 GHz is smaller than 0 dB, the transmission mode in the frequency smaller than about 30 GHz generated in the rectangular waveguide becomes only TE₁₀ mode which is the fundamental transmission mode. Accordingly, the abnormal oscillation is prevented from being generated and thus the high-frequency amplifier for performing the stable amplifying operation can be obtained.

In this case, if the narrow width parts are formed at the location which the first semiconductor amplifying device and the second semiconductor amplifying device are inserted therebetween, the space between the input port and output port of the first high-frequency amplifying circuit part and the space between the input port and output port of the second high-frequency amplifying circuit part are shield and separated by the narrow width parts, respectively. Accordingly, by the simple structure, the abnormal oscillation is prevented from being generated and thus the high-frequency amplifier for performing the stable amplifying operation can be obtained.

Moreover, if the narrow width parts are formed at the location which the conducting band is inserted therebetween, the first high-frequency amplifying circuit part and the second high-frequency amplifying circuit part are shield and separated. Accordingly, by the simple structure, the abnormal oscillation is prevented from being generated and thus the high-frequency amplifier for performing the stable amplifying operation can be obtained.

### BRIEF DESCRIPTION OF THE DRAWINGS

Fig. 1 is a plan view of a high-frequency amplifier according to a first embodiment of the present invention;
Fig. 2 is a plan view of a high-frequency amplifier according to a second embodiment of the present invention;
Fig. 3 is a plan view of a high-frequency amplifier according to a third embodiment of the present invention;
Fig. 4 is a cross-sectional view showing the structure of main parts of a conventional satellite broadcast receiving down converter; and
Fig. 5 is a plan view showing an example of the structure of the high-frequency amplifier used in the conventional satellite broadcast receiving down converter.

### DESCRIPTION OF THE PREFERRED EMBODIMENT

Hereinafter, the embodiments of the present invention will be described with reference to the attached drawings.

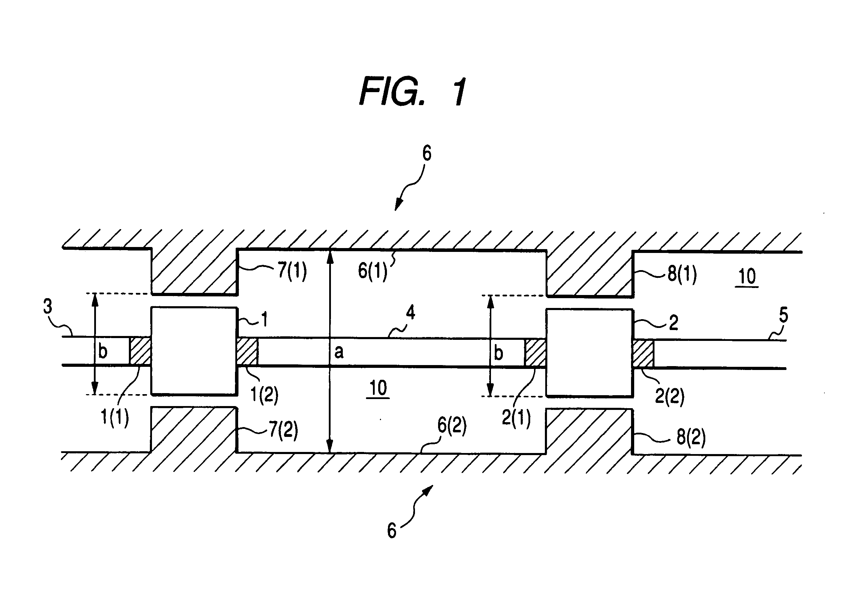

Fig. 1 is a plan view of a high-frequency amplifier according to a first embodiment of the present invention.

As shown in Fig. 1, the high-frequency amplifier according to the first embodiment of the present invention is formed on a circuit board 10, and comprises a first high-frequency amplifying circuit part 1 having a first semiconductor amplifying device and comprising an input port 1(1) and an output port 1(2), a second high-frequency amplifying circuit part 2 having a second semiconductor amplifying device and comprising an input port 2(1) and output port 2(2), a first conducting band 3 which is connected between an amplifier input port (not shown) and the input port 1(1) of the first high-frequency amplifying circuit part 1, a second conducting band 4 which is connected between the output port 1(2) of the first high-frequency amplifying circuit part 1 and the input port 2(1) of the second high-frequency amplifying circuit part 2, a third conducting band 5 which is connected between the output port 2(2) of the second high-frequency amplifying circuit part 2 and an amplifier output port (not shown), and a shield case 6 for shielding each of the components 1~5 on the circuit board 10.

In this case, the shield case 6 has two facing sidewalls 6(1), 6(2). The two sidewalls 6(1), 6(2) are provided with narrow width parts 7(1), 7(2), 8(1), 8(2) which are protruded into the inner direction thereof, at the location which the first high-frequency amplifying circuit part 1 is formed and the location which the second high-frequency amplifying circuit part 2 is formed. Also, the sidewall interval b of the narrow width parts 7(1), 7(2) and the sidewall interval b of the narrow width parts 8(1), 8(2) are narrower than the sidewall interval a of other parts. For example, while the sidewall interval a is 7 mm, the sidewall interval b is 4.5 mm.

According to the above-mentioned structure, the space between the input port 1(1) and the output port 1(2) of the first high-frequency amplifying circuit part 1 and the space between the input port 2(1) and the output port 2(2) of the second high-frequency amplifying circuit part 2 are shield and separated by the narrow width parts 7(1), 7(2) and the narrow width parts 8(1), 8(2), respectively. Also, the feedback coupling from the output port 1(2) to the input port 1(1) of the first high-frequency amplifying circuit part 1 and the feedback coupling from the output port 2(2) to the input port 2(1) of the second high-frequency amplifying circuit part 2 are prevented. Accordingly, by the simple structure that the narrow width parts 7(1), 7(2) and the narrow width parts 8(1), 8(2) are provided, the abnormal oscillation is prevented from being generated and thus the high-frequency amplifier for performing the stable amplifying operation can be obtained.

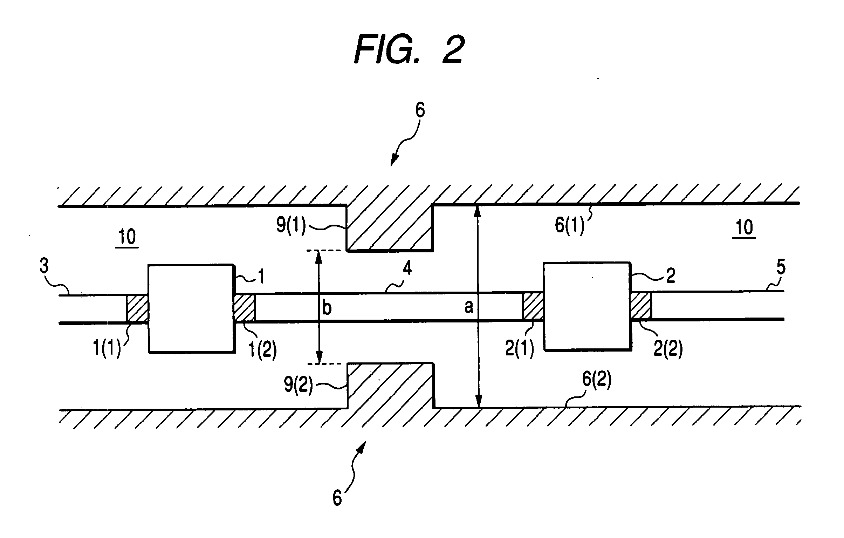

Next, Fig. 2 a plan view of a high-frequency amplifier according to a second embodiment of the present invention.

As shown in Fig. 2, the high-frequency amplifier according to the second embodiment is different from that of the first embodiment in the location which the narrow width parts of two sidewalls 6(1), 6(2) are formed and is similar to that of the first embodiment in the other structures. Thereby, the description for the structure of the high-frequency amplifier according to the second embodiment will be omitted except for the below-mentioned location of the narrow width parts. Also, in Fig. 2, the same components as Fig. 1 are attached with same reference numerals.

In this case, the shield case 6 used in the high-frequency amplifier according to the second embodiment has two facing sidewalls 6(1), 6(2). The two sidewalls 6(1), 6(2) are provided with narrow width parts 9(1), 9(2) protruded in the inner direction thereof at a portion of the location which the second conducting band 4 is formed. Also, the sidewall interval b of the narrow width parts 9(1), 9(2) is narrower than the sidewall interval a of the other parts. For example, while the sidewall interval a is 7 mm, the sidewall interval b is 4.5 mm.

According to the above-mentioned structure, the space between the first high-frequency amplifying circuit part 1 and the second high-frequency amplifying circuit part 2 is substantially shield and separated by the narrow width parts 9(1), 9(2) and the feedback coupling state from the second high-frequency amplifying circuit part 2 to the first high-frequency amplifying circuit part 1 is cancelled. Accordingly, by the simple structure that the narrow width parts 9(1), 9(2) are provided, the abnormal oscillation is prevented from being generated and thus the high-frequency amplifier for performing the stable amplifying operation can be obtained.

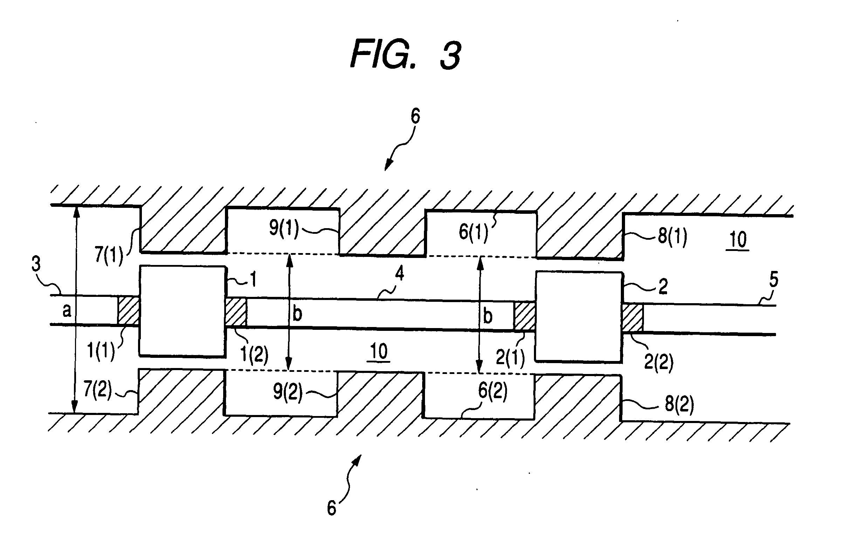

Next, Fig. 3 is a plan view of a high-frequency amplifier according to a third embodiment of the present invention.

As shown in Fig. 3, the high-frequency amplifier according to the third embodiment is different from those of the first and second embodiments in the location which the narrow width parts of two sidewalls 6(1), 6(2) are formed and is similar to those of the first and second embodiments in the other structures. Thereby, the description for the structure of the high-frequency amplifier according to the third embodiment will be omitted except for the below-mentioned location of the narrow width parts. Also, in Fig. 3, the same components as Figs. 1 and 2 are attached with same reference numerals.

In this case, the shield case 6 used in the high-frequency amplifier according to the third embodiment has two facing sidewalls 6(1), 6(2). The two sidewalls 6(1), 6(2) are provided with narrow width parts 7(1), 7(2), 8(1), 8(2) protruded in the inner direction thereof, at the location which the first high-frequency amplifying circuit part 1 is formed and the location which the second high-frequency amplifying circuit part 2 is formed. Also, the sidewalls 6(1), 6(2) are provided with narrow width parts 9(1), 9(2) protruded in the inner direction thereof at a portion of the location which the second conducting band 4 is formed. Further, the sidewall interval b of the narrow width parts 7(1), 7(2), the sidewall interval b of the narrow width parts 8(1), 8(2) and the sidewall interval b of the narrow width parts 9(1), 9(2) are narrower than the sidewall interval a of the other parts. For example, while the sidewall interval a is 7 mm, the sidewall interval b is 4.5 mm.

According to the above-mentioned structure, the space between the input port 1(1) and the output port 1(2) of the first high-frequency amplifying circuit part 1 and the space between the input port 2(1) and the output port 2(2) of the second high-frequency amplifying circuit part 2 are shield and separated by the narrow width parts 7(1), 7(2) and the narrow width parts 8(1), 8(2), respectively. Also, the feedback coupling from the output port 1(2) to the input port 1(1) of the first high-frequency amplifying circuit part 1 and the feedback coupling from the output port 2(2) to the input port 2(1) of the second high-frequency amplifying circuit part 2 are prevented. Further, the space between the first high-frequency amplifying circuit part 1 and the second high-frequency amplifying circuit part 2 is substantially shield and separated by the narrow width parts 9(1), 9(2) and the feedback coupling state from the second high-frequency amplifying circuit part 2 to the first high-frequency amplifying circuit part 1 is cancelled. Accordingly, by the simple structure that the narrow width parts 7(1), 7(2), 8(1), 8(2), 9(1), 9(2) are provided, the abnormal oscillation is prevented from being generated and thus the high-frequency amplifier for performing the stable amplifying operation can be obtained.

Furthermore, in each of the above-mentioned embodiment, the sidewall interval b of the narrow width parts 7(1), 7(2), the sidewall interval b of the narrow width parts 8(1), 8(2) and the sidewall interval b of the narrow width parts 9(1), 9(2) are, for example, set to 4.5 mm. If the sidewall interval b is too narrow, coupling between the first high-frequency amplifying circuit part 1 and the narrow width parts 7(1), 7(2), the coupling between the second high-frequency amplifying circuit part 2 and the narrow width parts 8(1), 8(2) and the coupling between the second conducting band 4 and the narrow width parts 9(1), 9(2) are generated and thus the loss of the high-frequency signal is generated or the amplifying characteristics of the first high-frequency amplifying circuit part 1 and the second high-frequency amplifying circuit part 2 are varied. On the other hand, if the sidewall interval b is too wide, the effect due to the sidewall interval b is weakened. Accordingly, in consideration of the above-mentioned matters, it is preferable that the sidewall interval b is in the range of 4 mm to 5 mm.

## Claims

1. A high-frequency amplifier, comprising a first high-frequency amplifying circuit part (1) which is formed on a circuit board and has a first semiconductor amplifying device, a second high-frequency amplifying circuit part (2) which is formed on the circuit board and has a second semiconductor amplifying device, a connecting part for connecting said first high-frequency amplifying circuit part with said second high-frequency amplifying circuit part by a conducting band (4), and a shield case (6) for shielding said first high-frequency amplifying circuit part, said connecting part and said second high-frequency amplifying circuit part, wherein the facing sidewalls (6(1),6(2)) of said shield case is provided with narrow width parts (7(1),7(2),8(1),8(2)) having an inner interval of 4 mm to 5 mm.

2. The high-frequency amplifier according to Claim 1, wherein said narrow width parts are formed at the location which said first semiconductor amplifying device and said second semiconductor amplifying device are inserted therebetween.

3. The high-frequency amplifier according to Claim 1, wherein said narrow width parts are formed at the location which said conducting band is inserted therebetween.

## Patentansprüche

1. Hochfrequenzverstärker, aufweisend einen ersten Hochfrequenzverstärkerschaltungsteil (1), der auf einer Leiterplatte gebildet ist und eine erste Halbleiterverstärkervorrichtung hat, einen zweiten Hochfrequenzverstärkerschaltungsteil (2), der auf der Leiterplatte gebildet ist und eine zweite Halbleiterverstärkervorrichtung hat, einen Verbindungsteil für das Verbinden des ersten Hochfrequenzverstärkerschaltungsteil mit dem zweiten Hochfrequenzverstärkerschaltungsteil durch ein Leiterband (4) und ein Abschirmgehäuse (6) für das Abschirmen des ersten Hochfrequenzverstärkerschaltungsteils, des Verbindungsteils und des zweiten Hochfrequenzverstärkerschaltungsteils, wobei die einander zugewandten Seitenwände (6(1), 6(2)) des Abschirmgehäuses mit Teilen mit einer schmalen Breite (7(1), 7(2), 8(1), 8(2)) versehen sind, die einen inneren Abstand von 4 mm bis 5 mm haben.

2. Hochfrequenzverstärker nach Anspruch 1, wobei die Teile mit der schmalen Breite an der Stelle gebildet sind, an der die erste Halbleiterverstärkervorrichtung und die zweite Halbleiterverstärkervorrichtung dazwischen eingefügt sind.

3. Hochfrequenzverstärker nach Anspruch auf 1, wobei die Teile mit der schmalen Breite an der Stelle gebildet sind, an der das Leiterband dazwischen eingefügt ist.

## Revendications

1. Amplificateur haute fréquence, comprenant une première partie de circuit d'amplification haute fréquence (1) qui est formée sur une carte imprimée et comporte un premier dispositif amplificateur à semiconducteur, une deuxième partie de circuit d'amplification haute fréquence (2) qui est formée sur la carte imprimée et comporte un deuxième dispositif amplificateur à semiconducteur, une partie connexion pour connecter ladite première partie de circuit d'amplification haute fréquence avec ladite deuxième partie de circuit d'amplification haute fréquence au moyen d'une bande conductrice (4), et un boîtier de blindage (6) pour protéger ladite première partie de circuit d'amplification haute fréquence, ladite partie connexion et ladite deuxième partie de circuit d'amplification haute fréquence, les parois latérales en vis-à-vis (6(1), 6(2)) dudit boîtier de blindage étant pourvues de parties de faible largeur (7(1), 7(2), 8(1), 8(2)) ayant un intervalle intérieur de 4 mm à 5 mm.

2. Amplificateur haute fréquence selon la revendication 1, dans lequel lesdites parties de faible largeur sont formées en un endroit tel que ledit premier dispositif amplificateur à semiconducteur et ledit deuxième dispositif amplificateur à semiconducteur sont insérés entre elles.

3. Amplificateur haute fréquence selon la revendication 1, dans lequel lesdites parties de faible largeur sont formées en un endroit tel que ladite bande conductrice est inséré entre elles.
